# EUROPEAN PATENT SPECIFICATION

(11) **EP 0 335 620 B1**
(45) Date of publication and mention of the grant of the patent: **22.06.1994**
(21) Application number: 89302976.9
(22) Date of filing: 23.03.1989
(51) Int. Cl.: C08G 73/12, G11B 5/704, G03F 7/26

(54) **Novel polymeric compounds and recording medium employing same**
Polymere Verbindungen und Aufzeichnungsmedium daraus
Composés polymères et médium d'enregistrement utilisant ces composés

(30) Priority: 28.03.1988 JP 71764/88
(43) Date of publication of application: 04.10.1989
(73) Proprietor: CANON KABUSHIKI KAISHA, Tokyo (JP)
(72) Inventor: Kawada, Haruki, Yokohama-shi Kanagawa-ken (JP); Takamatsu, Osamu, Atsugi-shi Kanagawa-ken (JP); Yanagisawa, Yoshihiro, Atsugi-shi Kanagawa-ken (JP); Eguichi, Ken, Yokohama-shi Kanagawa-ken (JP)
(74) Representative: Beresford, Keith Denis Lewis

(56) References cited:
- EP-A- 0 230 539
- US-A- 4 622 383
- US-A- 4 670 535
- Polymer Surfaces and Interfaces, ed. W J Feast and H Munro. pub J Wiley, 1987, p. 163 et seq
- R Jones et al., Polymer, 1987, vol. 28, pp. 1619-1626

## Description

The present invention relates to a recording method in which a recording medium having a thin film comprising a polyamic salt or ester is irradiated with an electron beam or X-rays.

In the preparation of resist patterns used in the manufacture of semiconductor devices or for the preparation of patterned resins serving as originals in the manufacture of printing plates, a polymerizable or decomposable resin film formed on a substrate is generally used. The film is patternwise irradiated with energy e.g. from electron beams or ultra-violet rays after which development is carried out to form the desired pattern. These patterns of resin or resist, however, are now required to be made finer to permit the manufacturer of semiconductor devices at higher density or to provide prints of higher quality. In particular there is a need to be able to make resist patterns of sub-micron order with good precision during the manufacture of VLSI. There is a need for resin films which are sensitive not only to electron beams or ultra-violet rays but also to X-rays or soft X-rays. It is desirable that the film should exhibit high sensitivity and also high resolution. In order to improve the resolution, it is desirable that the resist or resin film should be uniform, homogenous and as thin as possible.

In the development step, in order to produce patterns of sub-micron order, it is preferred to use wet rather than dry etching during the development. From this standpoint, resistance to dry etching has now become a requirement for a suitable resist or resin film. At present there is no material which adequately satisfies all these requirements.

The present invention provides a recording method comprising the steps of:
a) irradiating a recording medium with an electron ray or an X ray, said recording medium comprising a substrate and a thin film formed on the surface thereof, said thin film comprising a polyamic acid salt or polyamic acid ester having a weight average molecular weight of from 20000 to 3000000 and represented by the Formula (1): 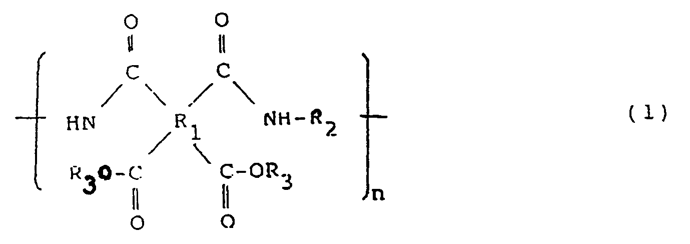 wherein R₁ represents a tetravalent group containing at least 6 carbon atoms and having a benzene nucleus; R₂ represents a divalent group containing at least 2 carbon atoms or having a benzene nucleus; R₃ is represented by the following Formula (2): 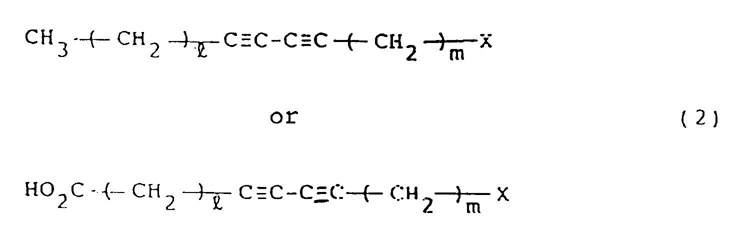 wherein l = 0 to 18, m = 0 to 8, and X = None, -N⁺H(CH₃)₂, or -N⁺H(C₂H₅)₂, to carry out patterning: and
b) etching the resulting recording medium.

The resist or film used in the above method can exhibit a combination of high sensitivity, high resolution and good resistance to dry etching. The invention will be further described with references to the accompanying drawings in which:

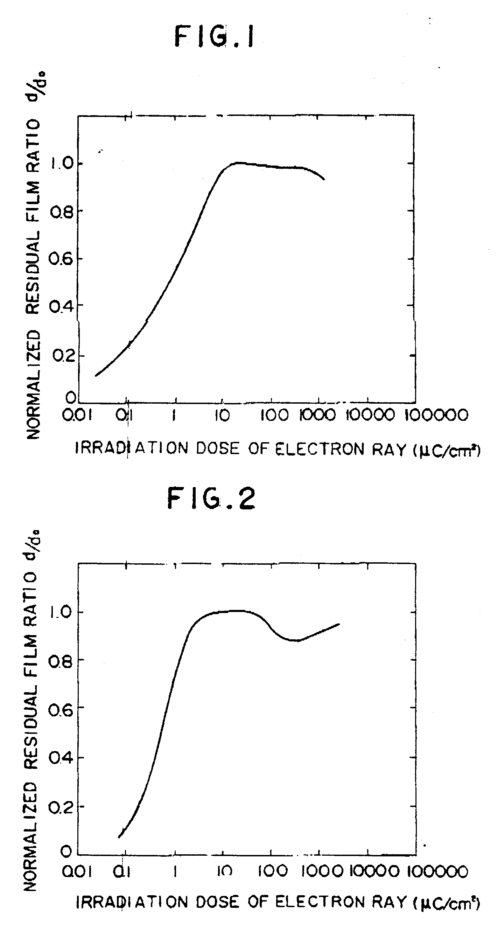

Figure 1 is a graph showing the relationship between an irradiation does of electron rays and a normalized residual film ratio (d/dₒ, wherein dₒ represents a thickness of the resist before electron ray irradiation, and d represents a thickness of the resists after etching) in a resist pattern of PAAD-DA12-8, formed by a coating process, according to the present invention; and
Fig. 2 is a graph showing the relationship between an irradiation dose of electron rays and a normalized residual film ratio in a resist pattern of PAAD-DA12-8, formed by the Langmuir-Blodgett process, according to the present invention.

### DETAILED DESCRIPTION OF THE PREFERRED EMBODIMENTS

The present invention provides a polymeric compound capable of changing solubility to solvents when a polymerizing energy is applied, said polymeric compound being incorporated with a polymerizable moiety, and also provides a resist or recording medium, characterized by employing the polymeric compounds.

The polymerizable moiety of the polymeric compound according to the present invention comprises a long-chain alkyl group having butadiyne (̵C≡C-C≡)̵, and participates in the formation of a resist pattern by application of the crosslinking energy as described herein.

The polymeric compound preferably includes polyamic acids, polyamic acid salts or polyamic acid esters incorporated with the above polymerizable moiety, as exemplified by a compound having the repeating unit represented by Formula (1). 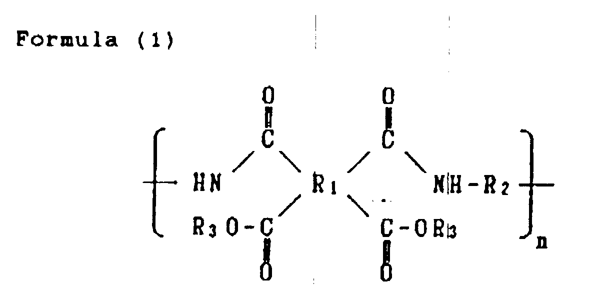
In the formula, R₁ represents a tetravalent group containing at least 6 carbon atoms, specifically including, for example, the following: 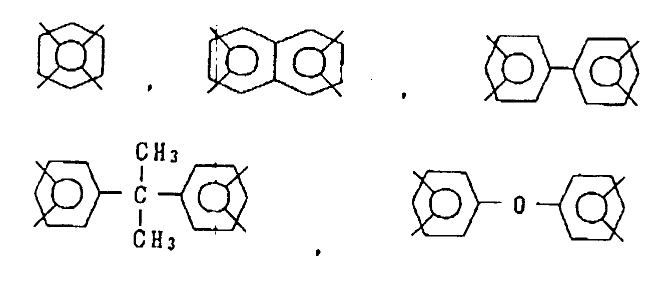
R₂ represents a divalent group containing at least 2 carbon atoms, specifically including, for example, the following: 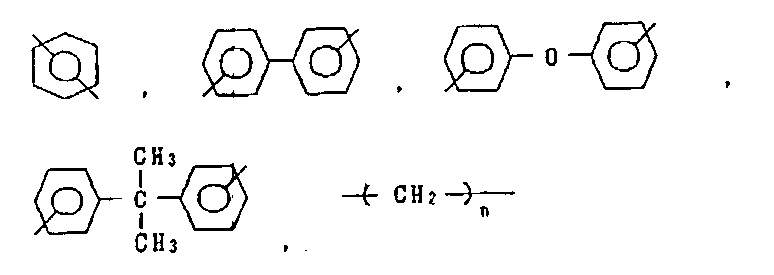
n = 2 ∼ 6 , 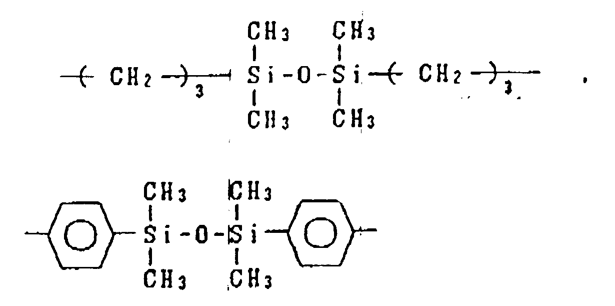
R₃ represents a monovalent group having at least 5 carbon atoms, or a quaternary ammonium salt having at least 7 carbon atoms, and has the structure represented by Formula (2). 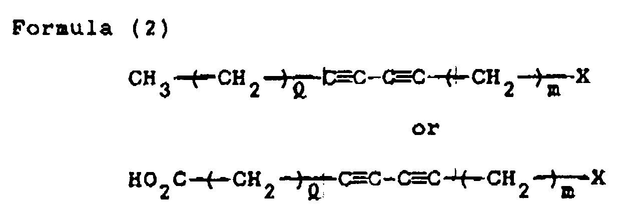
Q = 0 to 18, m = 0 to 8
X = None, -N^{⊕}H(CH₃)₂, -N^{⊕}H(C₂H₅)₂
In view of resistance to dry etching, it is particularly preferred for R₁ and/or R₂ of the polymeric compound represented by Formula (1) to have a benzene nucleus. Also, the incorporation of butadiyne into the long-chain alkyl group as represented by the above Formula (2) enables the compound to be polymerized with a high sensitivity to energy rays.

The polymeric compound should have a molecular weight (weight average) ranging between 20,000 and 3,000,000 (polymerization degree: 40 to 6,000), and a molecular weight outside this range is disadvantageous in the formation of resist films or resin films.

Additives such as a silane coupling agent may further be added without any problem so that resist properties such as adhesion can be enhanced.

Methods of forming a thin film by using the polymeric compound having the polymerizable moiety include a coating process and the Langmuir-Blodgett process. The coating process specifically includes spin coating and bar coating. The thin film has a thickness of from 0.1 »m to 2 »m, and preferably from 0.1 »m to 1 »m. The Langmuir-Blodgett process is a process also called a monomolecular film build-up process, which process comprises forming a monomolecular film on a water surface, regularly transferring and building up the resulting monomolecular film on a substrate to form a thin film. Employment of this Langmuir-Blodgett process makes it possible to control the thickness of the thin film in the order of angstroms and also obtain a homogeneous and uniform thin film. The monomolecular built-up film formed by the Langmuir-Blodgett process, using the polymeric compound represented by the above Formula (1), has a layer thickness of from 14 Å to 30 Å per one monomolecular layer, and is formed by building up such a monomolecular layer into a thin film with the desired thickness. The thin film has a film thickness distribution of not more than 200 Å, and is particularly excellent in the resolution of a recorded pattern. Namely, as compared with the coating process, thinner, more homogeneous and uniform films can be obtained, bringing about more improved sensitivity and more improved resolution when formed as polymerizable or decomposable thin films such as resist films.

To the thin films formed by the above processes, any of heat, near ultraviolet light, far ultraviolet light, electron rays, soft X rays, and X rays are applied as polymerizing energy, to form a resist pattern by causing changes in the solubility to solvent.

In the present invention, the employment of the polymeric compound having the polymerizable moiety makes it possible to provide a resist or recording medium having high resolution, having etching resistance with high sensitivity, and suited to lithography of submicron order or the like, and also makes it possible to form a resist or recording film having high resolution, and having dry etching resistance with high sensitivity.

The present invention as described above effects the following:
(1) A good polymerizability is exhibited in spite of a number of aromatic rings being contained, by incorporating into the polymerizable moiety of the polymerizable thin film material the butadiyne that enables polymerization with a very high sensitivity to energy rays.
(2) Because of the polymeric compound having a number of aromatic rings, a good dry etching resistance can be obtained.
(3) In particular, the polymerizable thin film prepared by the Langmuir-Blodgett process has the film thickness that can be controlled in the order of angstroms, and has such a good film quality that no pinholes are seen even in thin film of about 100 Å thick, and hence the sensitivity and resolution can be made still higher.
(4) In particular, the polymerizable thin film prepared by the Langmuir-Blodgett process has such a smooth film surface that there can be seen no sensitivity unevenness due to the difference in the place where the film is exposed to light.

The present invention will be described below in detail by giving Examples, but the present invention is by no means limited to these.

### Example 1

An Si substrate having subjected to hydrophobic treatment by leaving it to stand for 24 hours in a saturated vapor of hexamethyldisilazane (HMDS) was used, and a polyamic acid obtained from bis-(10-12 pentacosadiynoyl)pyromellitate and 4,4′-diaminodiphenyl ether (PAAD-DA12-8; molecular weight: 500,000) was dissolved in dimethylformamide at a concentration of 10 % (weight/weight) to prepare a PAAD-DA12-8 solution. The above Si substrate was mounted on a rotary head of a spinner, and 0.5 mℓ of the PAAD-DA12-8 solution was dropped on the substrate. Thereafter the head was rotated at 400 rpm for 10 seconds and further at 4,000 rpm for 30 seconds, thereby forming a thin film on the substrate. To remove the solvent, the substrate on which the thin film was formed was put in an oven capable of being maintained under reduced pressure, which was evacuated to 100 mmHg, followed by heating treatment at 120°C for 30 minutes.

The substrate having the above thin film was put in an electron ray patterning apparatus ELS-3300 (manufactured by Elionics Co.) to carry out patterning at an acceleration voltage of 20 kV and an irradiation dose of 10 »C/cm². Dimethylformamide was used as a developing solution to carry out processing, heating treatment was further made at 350°C for 10 minutes, and thereby a pattern of 0.25 »m with a high resolution could be obtained. Under varied irradiation doses, Fig. 1 shows the relationship between the irradiation doses and residual film ratios. In Fig. 1, dₒ represents a thickness of the thin film before electron ray irradiation, and d represents a thickness thereof after etching.

### Example 2

An Si substrate having subjected to hydrophobic treatment by leaving it to stand for 24 hours in a saturated vapor of hexamethyldisilazane (HMDS) was used, and a polyamic acid obtained from bis-(3-5 octadecadiynoyl)pyromellitate and 4,4′-diaminodiphenyl ether (PAAD-DA12-2; molecular weight: 700,000) was dissolved in dimethylformamide at a concentration of 10 % (weight/weight) to prepare a PAAD-DA12-2 solution. The above Si substrate was mounted on a rotary head of a spinner, and 0.5 mℓ of the PAAD-DA12-2 solution was dropped on the substrate. Thereafter the head was rotated at 400 rpm for 10 seconds and further at 4,000 rpm for 30 seconds, thereby forming a thin film on the substrate. To remove the solvent, the substrate on which the thin film was formed was put in an oven capable of being maintained under reduced pressure, which was evacuated to 100 mmHg, followed by heating treatment at 120°C for 30 minutes.

The substrate having the above thin film was put in an electron ray patterning apparatus ELS-3300 (manufactured by Elionics Co.) to carry out patterning at an acceleration voltage of 20 kV and an irradiation dose of 10 »C/cm². Dimethylformamide was used as a developing solution to carry out processing, heating treatment was further made at 350°C for 10 minutes, and thereby a pattern of 0.25 »m with a high resolution could be obtained.

### Example 3

An Si substrate having subjected to hydrophobic treatment by leaving it to stand for 24 hours in a saturated vapor of hexamethyldisilazane (HMDS) was used, and a polyamic acid obtained from bis-(10-12 pentacosadiynoyl)pyromellitate and 4,4′-diaminodiphenyl ether (PAAD-DA12-8; molecular weight: 500,000) was formed into a thin film by the Langmuir-Blodgett process. To describe specifically, PAAD-DA12-8 was dissolved in dimethylformamide at a concentration of 1 x 10⁻³ % (weight/weight) to prepare a PAAD-DA12-8 solution, which was spread on an aqueous phase of pure water with a water temperature of 20°C, and the surface pressure was raised up to 25 mN/m to form a monomolecular film on the water surface. While keeping constant the surface pressure, the above substrate was put in and drawn out at a rate of 5 mm/min in the direction traversing the water surface, thereby forming two-layer monomolecular built-up film. Such operations were repeated to form a 100-layer monomolecular built-up film.

The substrate having the above monomolecular built-up film was put in an electron ray patterning apparatus ELS-3300 (manufactured by Elionics Co.) to carry out patterning at an acceleration voltage of 20 kV and an irradiation dose of 2 »m/cm². Dimethylformamide was used as a developing solution to carry out processing, heating treatment was further made at 350°C for 10 minutes, and thereby it was able to obtain a pattern of 0.25 »m with a high resolution. Under varied irradiation doses, Fig. 2 shows the relationship between the irradiation doses and residual film ratios. In Fig. 2, dₒ and d have the same definition as the instance of Fig. 1.

### Example 4

An Si substrate having subjected to hydrophobic treatment by leaving it to stand for 24 hours in a saturated vapor of hexamethyldisilazane (HMDS) was used, and a polyamic acid obtained from bis-(3-5 pentacosadiynoyl)pyromellitate and 4,4′-diaminodiphenyl ether (PAAD-DA12-2; molecular weight: 700,000) was formed into a thin film by the Langmuir-Blodgett process. To describe specifically, PAAD-DA12-2 was dissolved in dimethylformamide at a concentration of 1 x 10⁻³ % (weight/weight) to prepare a PAAD-DA12-2 solution, which was spread on an aqueous phase of pure water with a water temperature of 20°C, and the surface pressure was raised up to 25 mN/m to form a monomolecular film on the water surface. While keeping constant the surface pressure, the above substrate was put in and drawn out at a rate of 5 mm/min in the direction crossing the water surface, thereby forming two-layer monomolecular built-up film. Such operations were repeated to form a 100-layer monomolecular built-up film.

The substrate having the above monomolecular built-up film was put in an electron ray patterning apparatus ELS-3300 (manufactured by Elionics Co.) to carry out patterning at an acceleration voltage of 20 kV and an irradiation dose of 2 »C/cm². Dimethylformamide was used as a developing solution to carry out processing, heating treatment was further made at 350°C for 10 minutes, and thereby a pattern of 0.25 »m with a high resolution could be obtained.

### Example 5

A PAAD-DA12-8 thin film was formed in the same manner as Example 1, and patterning was carried out. Thereafter, plasma was allowed to be generated by using a gas comprising carbon tetrafluoride mixed with 5 % of oxygen, and Si was etched by using the plasma. As a result, there was obtained a pattern having a high resolution. In this occasion, Si was etched by plasma at an etching rate of 2,000 Å/min; and the PAAD-DA12-8 thin film was etched at an etching rate of, 100 Å/min. This revealed that the PAAD-DA12-8 thin film had a sufficient resistance to dry etching against the plasma of carbon tetrafluoride.

### Example 6

An Si substrate having subjected to hydrophobic treatment by leaving it to stand for 24 hours in a saturated vapor of hexamethyldisilazane (HMDS) was used, and a polyamic acid obtained from bis-(10-12 pentacosadiynoyl)pyromellitate and 4,4′-diaminodiphenyl ether (PAAD-DA12-8; molecular weight: 500,000) was dissolved in dimethylformamide at a concentration of 10 % (weight/weight) to prepare a PAAD-DA12-8 solution. The above Si substrate was mounted on a rotary head of a spinner, and 0.5 mℓ of the PAAD-DA12-8 solution was dropped on the substrate. Thereafter the head was rotated at 400 rpm for 10 seconds and further at 4,000 rpm for 30 seconds, thereby forming a thin film on the substrate. To remove the solvent, the substrate on which the thin film was formed was put in an oven capable of being maintained under reduced pressure, which was evacuated to 100 mmHg, followed by heating treatment at 120°C for 30 minutes.

The substrate having the above thin film was irradiated with X rays (Al target) through an X-ray mask. During the irradiation, exposure dose was set to 500 mJ/cm². Dimethylformamide was used as a developing solution to carry out processing, heating treatment was further made at 350°C for 10 minutes, and thereby it was able and thereby it was able to obtain a pattern of 0.5 »m with a high resolution.

## Claims

1. A recording method comprising the steps of:
a) irradiating a recording medium with an electron ray or an X ray, said recording medium comprising a substrate and a thin film formed on the surface thereof, said thin film comprising a polyamic acid salt or polyamic acid ester having a weight average molecular weight of from 20000 to 3000000 and represented by the Formula (1): 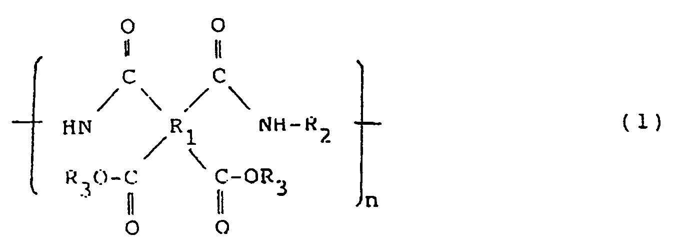 wherein R₁ represents a tetravalent group containing at least 6 carbon atoms and having a benzene nucleus; R₂ represents a divalent group containing at least 2 carbon atoms or having a benzene nucleus; R₃ is represented by the following Formula (2): 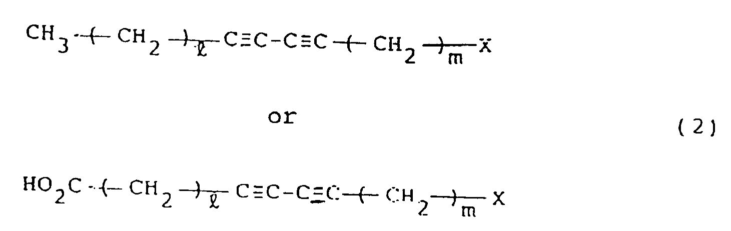 wherein l = 0 to 18, m = 0 to 8, and X = None, -N^{⊕}H(CH₃)₂, or -N^{⊕}H(C₂H₅)₂, to carry out patterning: and
b) etching the resulting recording medium.

2. The method of claim 1, wherein the thin film on the recording medium is spin coated or bar coated.

3. The method of claim 1 or 2, wherein the thin film on the recording medium has a film thickness of from 100 nm to 2 »m.

4. The method of claim 2, wherein the thin film on the recording medium has a thickness of 100 nm to 1 »m.

5. The method of any preceding claim, wherein the thin film is a monomolecular built-up film.

6. The method of claim 5, wherein the monomolecular built-up film has a layer thickness of from 1.4 nm to 3 nm per one monomolecular layer.

7. A recording method as claimed in any preceding claim, wherein in the compound of Formula (1), R₁ is represented by any of the following:

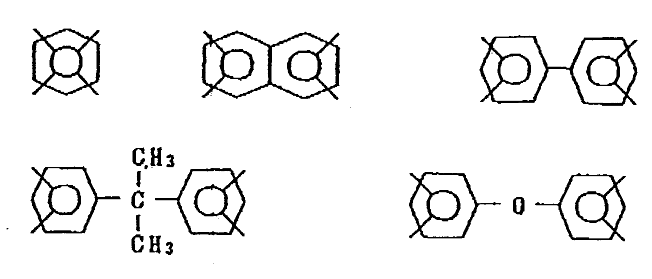

8. A method as claimed in any preceding claim, wherein in the compound of Formula (1), R₂ is represented by any of the following: 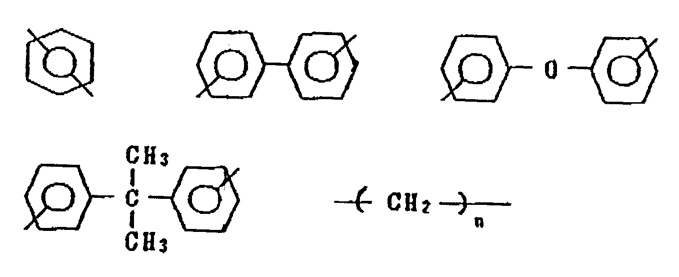 n = 2 ∼ 6 ,

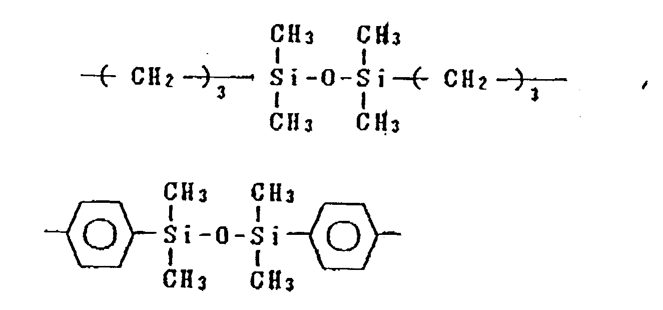

9. A method as claimed in any preceding claim, wherein the compound of Formula (1) is:
(a) a polyamic acid salt or ester obtained from bis-(10-12 pentacosadiynoyl)pyromellitate and 4,4'-diaminodiphenyl ether; or
(b) a polyamic acid salt or ester obtained from bis-(3-5 octadecadiynoyl) pyromellitate and 4,4'-diaminodiphenyl ether; or
(c) a polyamic acid salt or ester obtained from bis-(3-5 pentacosadiynoyl) pyromellitate and 4,4'-diaminodiphenyl ether.

10. A method according to any preceding claim, wherein the polymeric composition on the substrate constituting the thin film contains a silane coupling agent.

11. A method according to any preceding claim, wherein the substrate is treated, before application of the polyamic salt or polyamic ester, with hexamethyldisilazane.

12. A method according to claim 10, wherein the substrate is allowed to stand in a saturated vapour of hexamethyldisilazane.

13. A method according to any preceding claim, wherein the substrate is of silicon.

## Patentansprüche

1. Aufzeichnungsverfahren, welches die Schritte umfaßt, daß man
(a) ein Aufzeichnungsmedium mit einem Elektronenstrahl oder einem Röntgenstrahl bestrahlt, wobei das Aufzeichnungsmedium ein Substrat und einen dünnen Film umfaßt, der auf dessen Obefläche gebildet ist, wobei der dünne Film ein Polyamidsäure-Salz oder einen Polyamidsäure-Ester umfaßt, das/der ein Gewichtsmittel des Molekulargewichts von 20.000 bis 3.000.000 aufweist und durch die Formel (1) wiedergegeben wird 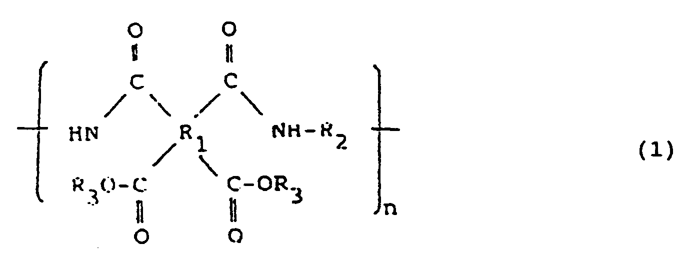 worin R₁ für eine vierwertige Gruppe steht, die wenigstens 6 Kohlenstoffatome enthält und einen Benzolkern aufweist, R₂ für eine zweiwertige Gruppe steht, die wenigstens zwei Kohlenstoffatome enthält oder einen Benzolkern aufweist, R₃ durch die folgende Formel (2) wiedergegeben wird 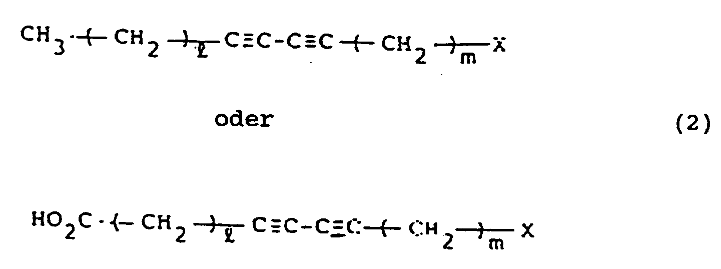 worin ℓ = 0 bis 18 ist, m = O bis 8 ist und X = nichts, -N⁺H(CH₃)₂ oder -N⁺H(C₂H₅)₂ ist, unter Bildung eines Musters; und
(b) das resultierende Aufzeichnungsmedium ätzt.

2. Verfahren nach Anspruch 1, worin der dünne Film als Beschichtung im Schleuderverfahren (spin coating) oder im Rakelverfahren (bar coating) auf dem Aufzeichnungsmedium aufgebracht wird.

3. Verfahren nach Anspruch 1 oder 2, worin der dünne Film auf dem Aufzeichnungsmedium eine Filmdicke von 100 nm bis 2 »m aufweist.

4. Verfahren nach Anspruch 2, worin der dünne Film auf dem Aufzeichnungsmedium eine Dicke von 100 nm bis 1 »m aufweist.

5. Verfahren nach einem der vorangehenden Ansprüche, worin der dünne Film ein monomolekularer Aufbaufilm ist.

6. Verfahren nach Anspruch 5, worin der monomolekulare Aufbaufilm eine Schichtdicke von 1,4 nm bis 3 nm aufweist, bezogen auf eine monomolekulare Schicht.

7. Aufzeichnungsverfahren nach einem der vorangehenden Ansprüche, worin in der Verbindung der Formel (1) der Rest R₁ durch einen der folgenden Reste wiedergeben wird:

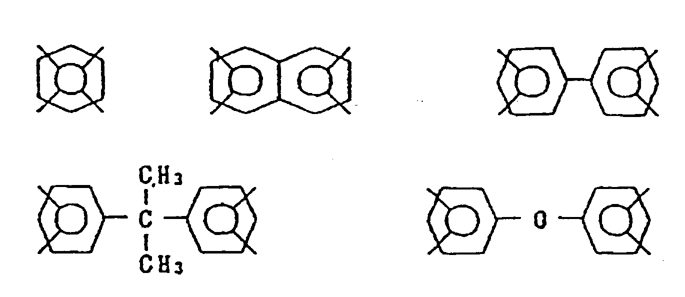

8. Verfahren nach einem der vorangehenden Ansprüche, worin in der Verbindung der Formel (1) der Rest R₂ durch einen der folgenden Reste wiedergegeben wird: 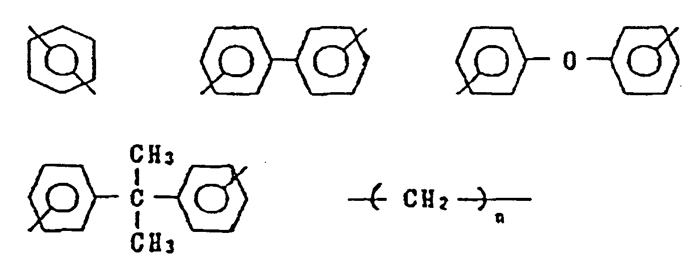 n = 2 ∼ 6 ,

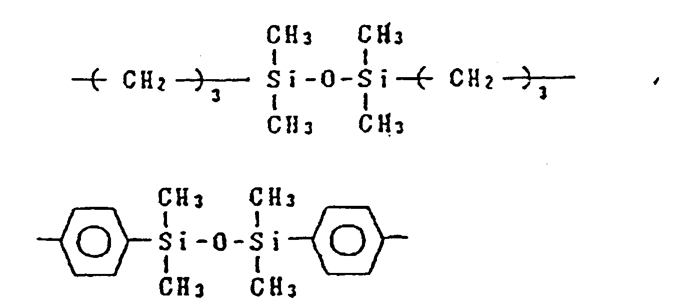

9. Verfahren nach einem der vorangehenden Ansprüche, worin die Verbindung der Formel (1)
(a) ein Polyamidsäure-Salz oder -Ester ist, das der aus Bis(10-,12-pentacosadiinoyl)pyromellitat und 4,4'-Diaminodiphenylether erhalten wird; oder
(b) ein Polyamidsäure-Salz oder -Ester ist, das der aus Bis(3-,5-octadecadiinoyl-)pyromellitat und 4,4'-Diaminodiphenylether erhalten wird; oder
(c) ein Polyamidsäure-Salz oder -Ester ist, das/der aus Bis(3-,5-pentacosadiinoyl-)pyromellitat und 4,4'-Diaminodiphenylether erhalten wird.

10. Verfahren nach einem der vorangehenden Ansprüche, worin die Polymerzubereitung auf dem Substrat, die den dünnen Film bildet, ein Silan-Kupplungsmittel enthält.

11. Verfahren nach einem der vorangehenden Ansprüche, worin das Substrat vor der Aufbringung des Polyaminsäure-Salzes oder des Polyaminsäure-Esters mit Hexamethyldisilazan behandelt wird.

12. Verfahren nach Anspruch 10, worin man das Substrat in einem gesättigten Hexamethyldisilazan-Dampf stehenläßt.

13. Verfahren nach einem der vorangehenden Ansprüche, worin das Substrat aus Silicium besteht.

## Revendications

1. Procédé d'enregistrement, comprenant les étapes :
a) d'irradiation d'un support d'enregistrement avec un faisceau d'électrons ou un rayonnement X, ledit support d'enregistrement comprenant un substrat et un film mince formé sur la surface de ce substrat, ledit film mince comprenant un sel d'acide polyamique ou un ester d'acide polyamique ayant une moyenne pondérale du poids moléculaire de 20 000 à 3 000 000 et qui est représenté par la formule (1) : 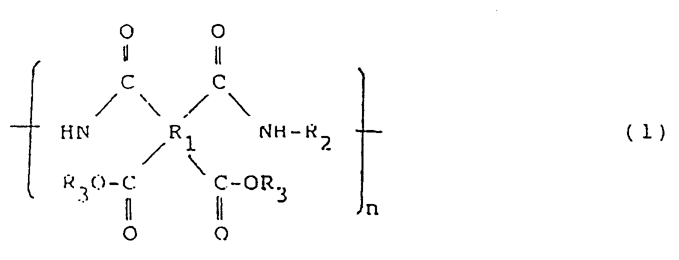 dans laquelle R₁ représente un groupe tétravalent contenant au moins 6 atomes de carbone et possédant un noyau benzénique ; R₂ représente un groupe divalent contenant au moins 2 atomes de carbone ou possédant un noyau benzénique ; R₃ est représenté par la formule (2) suivante : 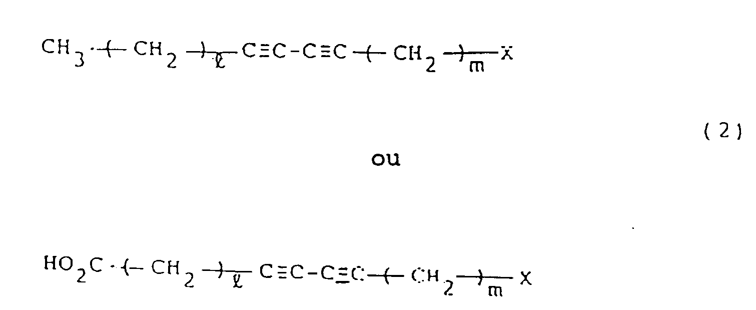 dans laquelle l a une valeur de 0 à 18, m à une valeur de 0 à 8 et X est absent ou représente un groupe -N^{⊕}H(CH₃)₂, ou -N^{⊕}H(C₂H₅)₂, pour effectuer la formation d'un motif ; et
b) d'attaque chimique du support d'enregistrement résultant.

2. Procédé suivant la revendication 1, dans lequel le film mince sur le support d'enregistrement est produit par revêtement centrifuge ou enduction par barre d'application.

3. Procédé suivant la revendication 1 ou 2, dans lequel le film mince sur le support d'enregistrement possède une épaisseur de film de 100 nm à 2 »m.

4. Procédé suivant la revendication 2, dans lequel le film mince sur le support d'enregistrement possède une épaisseur de 100 nm à 1 »m.

5. Procédé suivant l'une quelconque des revendications précédentes, dans lequel le film mince est un film formé par accumulation de couches monomoléculaires.

6. Procédé suivant la revendication 5, dans lequel le film formé par accumulation de couches monomoléculaires possède une épaisseur de 1,4 nm à 3 nm par couche monomoléculaire.

7. Procédé d'enregistrement suivant l'une quelconque des revendications précédentes, dans lequel, dans le composé de formule (1), R₁ est représenté par l'une quelconque des formules suivantes :

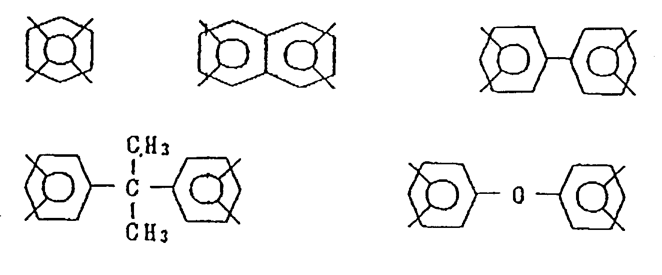

8. Procédé suivant l'une quelconque des revendications précédentes, dans lequel, dans le composé de formule (1), R₂ est représenté par l'une quelconque des formules suivantes : 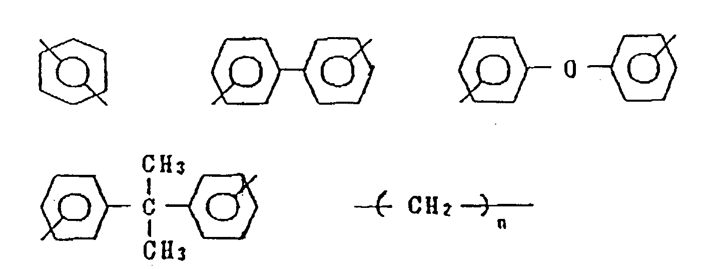 n = 2 ∼ 6 ,

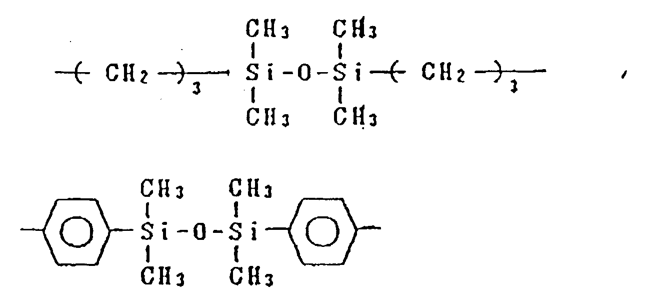

9. Procédé suivant l'une quelconque des revendications précédentes, dans lequel le composé de formule (1) est :
(a) un sel ou ester d'acide polyamique obtenu à partir de pyromellitate de bis-(10,12-pentacosadiynoyle) et d'éther de 4,4'-diaminodiphényle ; ou
(b) un sel ou ester d'acide polyamique obtenu à partir de pyromellitate de bis-(3,5-octadécadiynoyle) et d'éther de 4,4'-diaminodiphényle ; ou
(c) un sel ou ester d'acide polyamique obtenu à partir de pyromellitate de bis-(3,5-pentacosadiynoyle) et d'éther de 4,4'-diaminodiphényle.

10. Procédé suivant l'une quelconque des revendications précédentes, dans lequel la composition polymérique sur le substrat constituant le film mince contient un agent de couplage du type silane.

11. Procédé suivant l'une quelconque des revendications précédentes, dans lequel le substrat est traité, avant application du sel d'acide polyamique ou de l'ester d'acide polyamique, avec de l'hexaméthyldisilazane.

12. Procédé suivant la revendication 10, dans lequel on laisse le substrat au repos dans une vapeur d'hexaméthyldisilazane à saturation.

13. Procédé suivant l'une quelconque des revendications précédentes, dans lequel le substrat est constitué de silicium.
